# EUROPÄISCHE PATENTSCHRIFT

(11) **EP 2 295 991 B1**
(45) Veröffentlichungstag und Bekanntmachung des Hinweises auf die Patenterteilung: **02.08.2017**
(21) Anmeldenummer: 09011425.7
(22) Anmeldetag: 07.09.2009
(51) Int. Cl.: G01R 13/40, G09G 3/14, H05B 33/08

(54) **Balkendiagrammanzeigevorrichtung**
Bar graph display device
Dispositif d'affichage à diagramme en bâtons

(43) Veröffentlichungstag der Anmeldung: 16.03.2011
(73) Patentinhaber: VEGA Grieshaber KG, 77709 Wolfach (DE)
(72) Erfinder: Wöhrle, Siegbert, 77761 Schiltach (DE); Schultheiß, Daniel, 78132 Hornberg (DE); Fehrenbach, Josef, 77716 Haslach (DE); Deck, Thomas, 77709 Wolfach (DE); Fischer, Michael, 77709 Wolfach (DE)
(74) Vertreter: Westphal, Mussgnug & Partner Patentanwälte mbB

(56) Entgegenhaltungen:
- EP-A1- 1 656 001
- DE-A1- 2 251 822
- DE-A1- 2 614 712
- US-A- 4 348 666
- US-A1- 2005 248 409
- IRAZABAL J-M ET AL: "AN264 I2C DEVICES FOR LED DISPLAY CONTROL" PHILIPS SEMICONDUCTORS APPLICATION NOTE, XX, XX, 22. Juli 2002 (2002-07-22), Seiten 1-27, XP002319313

## Beschreibung

Die Erfindung betrifft eine Ansteuerschaltung einer Anzeigevorrichtung gemäß dem Oberbegriff des Patentanspruchs 1 und eine Anzeigevorrichtung gemäß Patentanspruch 2.

Derartige Anzeigevorrichtung sind aus dem Stand der Technik als Balkenanzeigen bekannt. Die bekannten Balkenanzeigen bestehen aus einer Anzahl von balkenförmig in einer Reihe angeordneten Anzeigeelementen, wobei zur Anzeige eines bestimmten Wertes entweder ein einzelnes, dem Wert zugeordnetes Anzeigeelement, oder ausgehend von einem Ende des Balkens sämtliche Anzeigeelemente bis zu dem, dem Wert zugeordneten Anzeigeelement aktiviert werden.

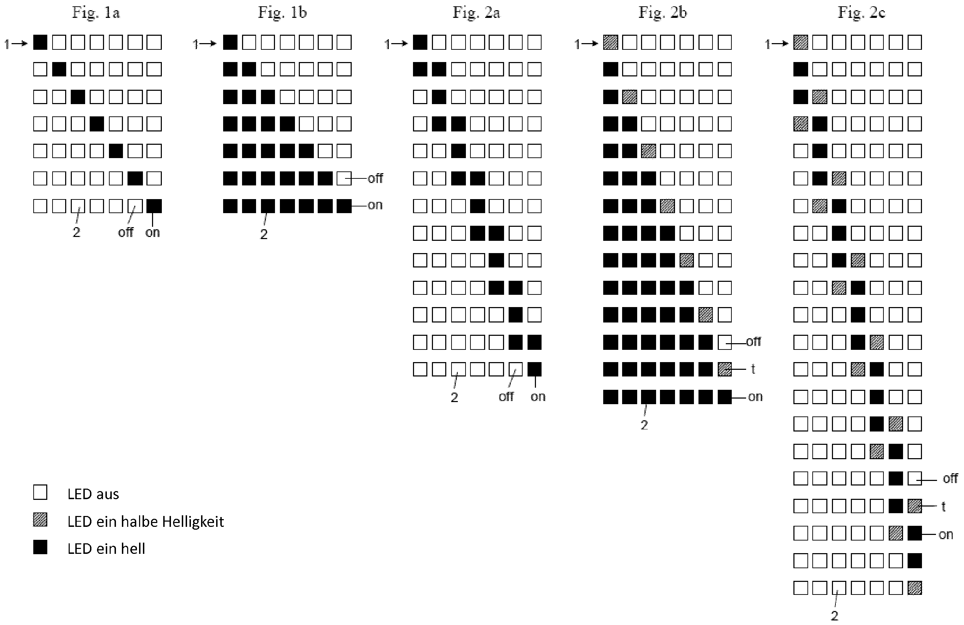

In den Figuren 1a und 1b sind solche aus dem Stand der Technik bekannten Anzeigevorrichtungen dargestellt.

Figur 1a zeigt eine Balkenanzeige 1 mit sieben Anzeigeelementen 2, wobei zur Darstellung eines Wertes jeweils nur eines der Anzeigeelemente 2 aktiviert ist. Mit der Anzeigevorrichtung gemäß Figur 1a können also durch die sieben Anzeigeelemente 2 genau sieben Zustände eindeutig dargestellt werden.

Figur 1b zeigt die zweite bekannte Ausführungsvariante solcher Anzeigevorrichtungen 1, bei der zur Darstellung eines bestimmtes Wertes ausgehend von einem Ende der balkenförmig angeordneten Anzeigeelemente 2 sämtliche Anzeigeelemente 2 bis zu einem dem anzuzeigenden Wert zugeordneten Anzeigeelement 2 aktiviert werden. Auch in dem in Figur 1b dargestellten Beispiel können mit sieben Anzeigeelementen 2 maximal sieben Werte oder Zustände eindeutig dargestellt werden.

Aus dem Stand der Technik ist es weiterhin bekannt, die anzuzeigenden Werte zu codieren und auch die Darstellung in codierte Weise vorzunehmen. Beispielsweise können darzustellende Messwerte binär codiert und entsprechend dieser Codierung dargestellt werden. Die einzelnen Anzeigeelemente sind bei einer binären Codierung jeweils Zweierpotenzen zugeordnet, sodass mit sieben Anzeigeelementen maximal 2⁷, d. h. 128 Werte darstellbar sind. Eine derartige Codierung geht jedoch zu Lasten einer einfachen Ablesbarkeit, sodass Codierungen in Einsatzbereichen in denen eine schnelle präzise und einfache Ablesbarkeit gewährleistet sein muss nicht einsetzbar sind.

Als weiterer Stand der Technik werden die US 4,348,666, die DE 22 51 822 A1 sowie die EP 1 656 001 A1 genannt.

Die US 4,348,666 offenbart eine Anzeigevorrichtung, die Signale abhängig von deren Stärke in Helligkeitsstufen mittels in einer Reihe angeordneter Leuchtelementen als Balkenanzeige darstellt.

Die DE 22 51 822 A1 offenbart ein Größenpegelmesser mit einer Anzahl lichtemittierender Anzeiger zum Anzeigen des Pegels einer Größe.

Die EP 1 656 001 A1 offenbart eine Blitzlichteinrichtung mit einer zentralen Prozessoreinheit mit einer Vielzahl von universal Eingangs-/Ausgangskontaktstiften, einer Treiberschaltung und einem Lichtmodul, das mit der Treiberschaltung verbunden ist. Bei der Treiberschaltung werden tri-state Eigenschaften der Ausgänge verwendet, um das Lichtmodul in drei verschiedenen Ausgangszuständen (ein, aus, blinkend) zu schalten.

Es ist die Aufgabe der vorliegenden Erfindung, eine Ansteuerschaltung einer Anzeigevorrichutng und eine Anzeigevorrichtung zur Verfügung zu stellen, wobei die Ansteuerschaltung es ermöglicht, ein Anzeigeelement einer Anzeigevorrichtung in mehr als einer Helligkeitsstufe anzusteuern und wobei die Anzeigevorrichtung eine einfache, zuverlässige und schnelle Ablesbarkeit gewährleistet und dennoch die Darstellung eines vergrößerten Wertebereiches ermöglicht.

Diese Aufgabe wird gelöst durch eine Ansteuerschaltung einer Anzeigevorrichtung mit den Merkmalen des Patentanspruchs 1 und eine Anzeigevorrichtung mit den Merkmalen des Patentanspruchs 2.

Bei der erfindungsgemäßen Ansteuerschaltung für eine Anzeigevorrichtung mit einer Anzahl an balkenförmig angeordneten Anzeigeelementen, ist jedes Anzeigeelement eingerichtet um einen ersten Anzeigezustand, einen zweiten Anzeigezustand und einen dritten Anzeigezustand zur Anzeige eines Zwischenwertes zwischen dem anzuzeigenden Wert und einem nachfolgenden oder einem vorhergehenden Wert durch Aktivierung des vorhergehenden oder nachfolgenden Anzeigeelementes darzustellen, und um einen anzuzeigenden Wert durch den zweiten Anzeigezustand wenigstens eines dem Wert zugeordneten Anzeigeelementes anzuzeigen.

Eine erfindungsgemäße Anzeigevorrichtung weist eine erfindungsgemäße Ansteuerschaltung auf und zeichnet sich dadurch aus, dass der erste Anzeigezustand durch einen jeweiligen ersten Ausgangszustand, der zweite Anzeigezustand durch einen jeweiligen zweiten Ausgangszustand und der dritte Anzeigezustand durch einen jeweiligen dritten Ausgangszustand eines Mikroprozessors angesteuert ist.

Die vorliegende Erfindung macht sich damit einerseits die einfach Ablesbarkeit von Balkenanzeigen zu nutze und ermöglicht andererseits durch die Aktivierung eines vorhergehenden oder nachfolgenden Anzeigeelementes dass Zwischenwerte dargestellt werden können. Wenn ein einzelner darzustellender Wert durch die Aktivierung eines einzelnen Anzeigeelementes dargestellt wird, so können Zwischenzustände zwischen dem darzustellen Wert und einem nachfolgenden Wert durch gleichzeitige Aktivierung des dem anzuzeigenden Wert zugeordneten Anzeigeelementes und des nachfolgenden Anzeigeelementes dargestellt werden. Eine Anzeige mit beispielsweise sieben Anzeigelementen kann somit zusätzlich zu den sieben bisher darstellbaren Werten sechs weitere Zwischenwerte anzeigen, sodass insgesamt eine Anzeige von 13 unterschiedlichen Zuständen möglich ist. Erfindungsgemäß ist es möglich, dass durch jedes Anzeigelement zur Anzeige der Zwischenwerte ein dritter Anzeigezustand darstellbar ist.

Durch einen dritten Anzeigezustand der bei Verwendung von Leuchtdioden als Anzeigeelemente beispielsweise durch eine Ansteuerung der Leuchtdioden mit halber Helligkeit realisiert werden kann, ist es ebenso möglich weitere Anzeigezustände darzustellen und dennoch die schnelle und eindeutige Ablesbarkeit einer Balkenanzeige zu bewahren.

Dies ist beispielsweise dadurch möglich, dass der anzuzeigende Wert durch den zweiten Zustand eines diesem Wert zugeordneten Anzeigeelementes und sämtlicher vorhergehender Anzeigeelemente dargestellt wird und dass der Zwischenwert zu dem nachfolgenden Wert durch die zusätzliche Aktivierung des nachfolgenden Anzeigeelementes in dem dritten Zustand, also beispielsweise mit halber Helligkeit, signalisiert wird.

Eine derartige Anzeigevorrichtung hat den Vorteil, dass durch die Anzahl der Leuchtdioden auf einem Blick erkennbar ist, in welchem Bereich sich der anzuzeigende Wert befindet und dass außerdem auf Grund des direkten Vergleichs sofort erkannt wird, ob eine gegebenenfalls zusätzliche Leuchtdiode mit voller oder halber Helligkeit betrieben wird.

Eine weitere Anzeigemöglichkeit ist dadurch gegeben, dass ein anzuzeigender Wert durch Aktivierung eines einzelnen Anzeigeelementes darstellbar ist und dass der Zwischenwert zu dem nachfolgenden oder dem vorhergehenden Wert durch den dritten Zustand des nachfolgenden oder des vorhergehenden Anzeigeelementes darstellbar ist.

Auf diese Weise ist es möglich insgesamt 21 Zustände mit sieben Anzeigeelementen zu signalisieren wobei ausgehend von einem anzuzeigenden Wert jeweils die Möglichkeit besteht einen Zwischenwert unterhalb und einen Zwischenwert oberhalb des anzuzeigenden Wertes darzustellen. Der Vorteil liegt darin, dass bei einer weiterhin guten Ablesbarkeit eine erheblich vergrößerte Anzahl an Werten darstellbar ist. Im Vergleich zu einer herkömmlichen Anzeigevorrichtung nach dem Stand der Technik können dreimal so viele Werte dargestellt werden, sodass im Vergleich zum Stand der Technik nur noch ein Drittel der Materialkosten für die Anzeigevorrichtung anfällt

Eine besonders einfache Realisierung der vorstehend beschriebenen Anzeigevorrichtungen kann mit Leuchtdioden erreicht werden, die in drei Helligkeitsstufen angesteuert werden.

Für die Ansteuerung der Anzeigeelemente beziehungsweise der Leuchtdioden ist die Ansteuerschaltung vorgesehen.

Ein bevorzugter Anwendungsbereich der oben beschriebenen Anzeigevorrichtung liegt im Bereich der Füllstandsmessgeräte, da in diesem Anwendungsbereich insbesondere eine eindeutige und schnelle Ablesbarkeit eine große Rolle spielen.

Die Ansteuerschaltung für die oben beschriebene Anzeigevorrichtung ist erfindungsgemäß derart ausgebildet, dass der erste Zustand der Anzeigeelemente durch eine erste Stromstärke, der zweite Zustand durch eine zweite Stromstärke und der dritte Zustand durch eine dritte Stromstärke angesteuert wird. Die dritte Stromstärke liegt zwischen der ersten Stromstärke und der zweiten Stromstärke, was bei der Verwendung von Leuchtdioden einem Betrieb der Leuchtdiode mit verringerter Helligkeit entspricht.

Bei einer Ansteuerung von Leuchtdioden beträgt die zweite Stromstärke etwa dem Nennstrom der Leuchtdiode, die erste Stromstärke beträgt etwa 0 Ampere und die dritte Stromstärke ist im Bereich des halben Nennstroms der Leuchtdiode angesiedelt.

Zusätzlich zu einem Ein-Zustand bei dem Nennstrom und einem Aus-Zustand bei 0 Ampere wird damit ein dritter Zustand mit etwa halber Helligkeit bei etwa dem halben Nennstrom erreicht. Der dritte Zustand ist einerseits gegenüber einer ausgeschalteten Leuchtdiode gut wahrnehmbar und kann andererseits auch gut von einer Leuchtdiode, die mit dem Nennstrom betrieben wird, unterschieden werden.

Die erfindungsgemäße Ansteuerschaltung ist mit einem Mikroprozessor mit je einem Ausgang zur Ansteuerung je eines Anzeigeelementes realisiert, wobei jeder der Ausgänge einen ersten Ausgangszustand, einen zweiten Ausgangszustand und einen dritten Ausgangszustand einnehmen kann. Zur Ansteuerung der Anzeigeelemente, die als Leuchtdiode realisiert sind, ist jeweils eine Eingangsschaltung für die Leuchtdioden vorgesehen. Die Eingangsschaltung ist aus einem Transistor aufgebaut, dessen Basis mit dem Ausgang des Mikroprozessors und über einen ersten Widerstand mit einer Versorgungsspannung verbunden ist. Der Kollektor des Transistors ist über einen zweiten Widerstand ebenfalls mit der Versorgungsspannung verbunden. Der Emitter des Transistors ist über eine Reihenschaltung aus einem dritten Widerstand und der Leuchtdiode mit Masse verbunden.

Durch die derartige Ansteuerschaltung ist es möglich, dass unter Verwendung lediglich eines Ausgangs des Mikroprozessors eine Leuchtdiode mit drei verschiedenen Helligkeitsstufen ansteuerbar ist. Es werden dazu die drei Zustände eines Tri-State-Ausgangs des Mikroprozessors genutzt.

In dem ersten Zustand ist der Ausgang des Mikroprozessors auf Masse geschaltet, sodass über den Transistor kein Strom fließen kann. Die Leuchtdiode ist aus. In dem zweiten Zustand ist der Ausgang des Mikroprozessors mit der Versorgungsspannung beschaltet, sodass durch die Leuchtdiode die Summe aus einem Basisstrom und einem Kollektorstrom des Transistors durch die Leuchtdiode fließt. Die Leuchtdiode wird mit voller Helligkeit betrieben. In dem dritten Zustand ist der Ausgang des Mikroprozessors hochohmig geschaltet, sodass der Basisstrom des Transistors durch den ersten Widerstand einstellbar ist. Die Leuchtdiode wird bei geeigneter Dimensionierung des Widerstands mit gedimmter, bevorzugt halber Helligkeit betrieben.

Die Erfindung wird nachfolgend unter Bezugnahme auf die beigefügten Figuren eingehend erläutert.

Es zeigen:
- Figur 1a: eine erste Balkenanzeige gemäß dem Stand der Technik,
- Figur 1b: eine zweite Balkenanzeige gemäß dem Stand der Technik,
- Figur 2a: eine dritte Balkenanzeige gemäß dem Stand der Technik,
- Figur 2b: eine vierte Balkenanzeige gemäß dem Stand der Technik,
- Figur 2c: eine fünfte Balkenanzeige gemäß dem Stand der Technik und
- Figur 3: ein Ausführungsbeispiel einer erfindungsgemäßen Ansteuerschaltung für ein Anzeigeelement einer erfindungsgemäßen Anzeigevorrichtung.

Die Figuren 2a bis 2c zeigen jeweils eine Anzeigenvorrichtung 1 mit sieben balkenförmig angeordneten Anzeigeelementen 2, wobei durch verschiedene Anzeigemethoden jeweils ein vergrößerter Anzeigebereich im Vergleich zu herkömmlichen Balkenanzeigen mit sieben Anzeigeelementen 2 erreicht wird.

Figur 2a zeigt die verschiedenen Anzeigezustände einer Anzeigevorrichtung 2, bei der ein anzuzeigender Wert durch die Aktivierung eines dem Wert zugeordneten Anzeigeelementes 2 erfolgt. Zwischenwerte zwischen einem anzuzeigenden Wert und einem nachfolgenden Wert werden durch die Aktivierung des dem zugeordneten Anzeigeelements 2 nachfolgenden Anzeigeelements 2 angezeigt.

Wenn beispielsweise durch die Anzeigevorrichtung 1 mit sieben Anzeigeelementen 2 die Werte 1 bis 7 angezeigt werden, so ist ein Wert von beispielsweise 2,5 durch Aktivierung des zweiten und des dritten Anzeigeelementes 2 darstellbar. Durch die Darstellung der Zwischenwerte können also insgesamt maximal 13 Anzeigestufen dargestellt werden.

Figur 2b zeigt die verschiedenen Anzeigezustände eines weiteren Ausführungsbeispiels einer Balkenanzeige. Bei dieser Ausgestaltungsform wird ein anzuzeigender Wert durch die Aktivierung des dem Wert zugeordneten Anzeigeelementes 2 sowie sämtliche vorhergehenden Anzeigeelemente 2 erfolgt. Zwischenwerte zu einem nachfolgenden Wert werden durch eine Aktivierung des nachfolgenden Anzeigeelements 2 mit verringerter Intensität, also beispielsweise halber Intensität, signalisiert.

Ein Wert von beispielsweise 2,5 wird damit also durch eine Aktivierung des ersten und des zweiten Anzeigeelements 2 mit voller Intensität und eine Aktivierung des dritten Anzeigeelements 2 mit halber Intensität dargestellt.

Wenn zusätzlich vorgesehen ist, dass das erste Anzeigeelement 2 mit voller Intensität und halber Intensität betrieben werden kann, so wird dadurch ein zusätzlicher Anzeigezustand gewonnen, sodass mit der in Figur 2b dargestellten Anzeigevorrichtung insgesamt 14 Anzeigezustände darstellbar sind.

Figur 2c zeigt die verschiedenen Anzeigezustände eines weiteren Ausführungsbeispiels einer Balkenanzeige.

Gemäß diesem dritten Ausführungsbeispiel wird eine anzuzeigender Wert durch Aktivierung eines einzelnen Anzeigeelements dargestellt, wobei Zwischenwerte zu einem vorhergehenden oder einem nachfolgenden Wert durch Aktivierung des vorhergehenden oder nachfolgenden Anzeigeelements dargestellt werden. Es ist damit möglich, zwischen einem anzuzeigenden Wert und einem nachfolgenden Wert zwei Zwischenzustände anzuzeigen. Beispielsweise können so die Werte 2 1/3 durch Aktivierung des zweiten Anzeigeelements mit voller Intensität und Aktivierung des dritten Anzeigeelements mit halber Intensität und der Wert 2 2/3 durch Aktivierung des dritten Anzeigeelements mit voller Intensität und durch Aktivierung des zweiten Anzeigelements mit halber Intensität dargestellt werden.

Mit der angegebenen Codierung ist es möglich mit einer sieben Anzeigeelemente umfassenden Balkenanzeige bis zu 21 Abstufungen anzuzeigen.

Die angegebenen beispielhaften Anzeigewerte dienen ausschließlich der Veranschaulichung der jeweils beschriebenen Anzeigevariante.

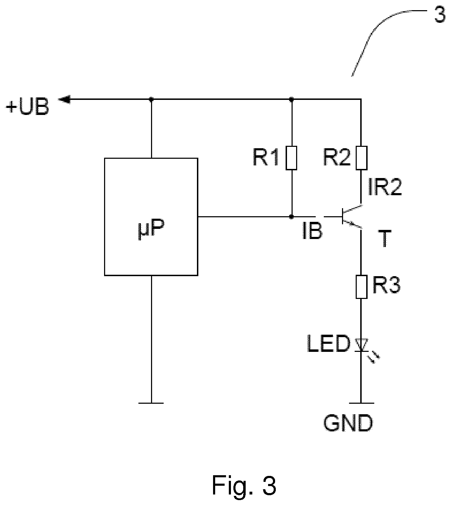

Figur 3 zeigt die erfindungsgemäße Ansteuerschaltung 3 für ein entsprechendes Anzeigeelement 2, die es ermöglicht eine als Anzeigeelement 2 verwendete Leuchtdiode in drei Helligkeitsstufen, nämlich mit voller Helligkeit, mit reduzierter Helligkeit und in einem Aus-Zustand anzusteuern.

Mit der erfindungsgemäßen Ansteuerschaltung 3 ist es möglich eine Leuchtdiode LED in drei Helligkeitsstufen anzusteuern und dabei nur einen Ausgang des Mikroprozessors µP zu benötigen.

Die erfindungsgemäße Ansteuerschaltung 3 umfasst einen Mikroprozessor µP dessen Tri-State-Ausgang an die Basis B eines Bipolartransistors T angeschlossen ist. Zwischen der Basis B und einer Versorgungsspannung UB ist ein erster Widerstand R1 angeordnet. Der Kollektor C des Bipolartransistors T ist über einen zweiten Widerstand R2 ebenfalls mit der Versorgungsspannung UB verbunden. Zwischen einem Masseanschluss GND und dem Emitter E des Bipolartransistors T ist eine Reihenschaltung aus einem dritten Widerstand R3 und einer Leuchtdiode LED als Anzeigeelement 2 angeordnet.

Der Tri-State-Ausgang des Mikroprozessors µP kann zur Ansteuerung des Bipolartransitors T drei verschiedenen Zustände annehmen. In einem ersten Zustand low ist der Ausgang auf Masse GND beziehungsweise 0 Volt geschaltet, sodass über den Bipolartrantsistor T kein Strom fließen kann. Die Leuchtdiode LED ist daher aus. In einem zweiten Ausgangszustand high ist der Ausgang des Mikroprozessors µP mit der Versorgungsspannung UB beschaltet, sodass die Leuchtdiode LED mit der Summe aus dem Basisstrom IB und einem über dem zweiten Widerstand R2 fließenden Strom IR2 angesteuert wird. Die Leuchtdiode LED leuchtet mit großer Helligkeit. In einem dritten Zustand in ist der Ausgang des Mikroprozessors µP als Eingang geschaltet und daher hochohmig. Über den ersten Widerstand R1 kann in diesem Zustand der Basisstrom IB über den Bipolartransistor T so eingestellt werden, dass die Leuchtdiode LED mit verringerter Helligkeit leuchtet.

### Bezugszeichenliste

- 1: Anzeigevorrichtung
- 2: Anzeigeelement
- 3: Ansteuerschaltung

- I1: erste Stromstärke
- I2: zweite Stromstärke
- I3: dritte Stromstärke

- IB: Basisstrom

- on: zweiter Anzeigezustand
- off: erster Anzeigezustand
- t: dritter Anzeigezustand

- high: zweiter Ausgangszustand
- low: erster Ausgangszustand
- in: dritter Ausgangszustand

- R1: erster Widerstand
- R2: zweiter Widerstand
- R3: dritter Widerstand

- T: Transistor
- B: Basis
- C: Kollektor
- E: Emitter

- µP: Mikroprozessor
- UB: Versorgungsspannung
- GND: Masse
- LED: Leuchtdiode

## Patentansprüche

1. Ansteuerschaltung (3) für eine Anzeigevorrichtung (1) mit einer Anzahl (n) an balkenförmig angeordneten Anzeigeelementen (2), wobei jedes Anzeigeelement (2) geeignet ist um einen ersten Anzeigezustand (off), einen zweiten Anzeigezustand (on) und einen dritten Anzeigezustand (t) darzustellen, wobei die Ansteuerschaltung (3) so ausgebildet ist, dass ein erster Wert durch den zweiten Anzeigezustand (on) wenigstens eines dem Wert zugeordneten Anzeigeelementes (2) dargestellt wird, und dass ein Zwischenwert zwischen dem ersten Wert und einem nachfolgenden oder einem vorhergehenden Wert durch gleichzeitige Aktivierung des vorhergehenden oder nachfolgenden Anzeigeelementes (2) dargestellt wird, und dass der erste Zustand (off) der Anzeigeelemente (2) durch eine erste Stromstärke (I1), der zweite Zustand (on) durch eine zweite Stromstärke (12) und der dritte Zustand (t) durch eine dritte Stromstärke (13) angesteuert wird, wobei die dritte Stromstärke (13) zwischen der ersten Stromstärke (I1) und der zweiten Stromstärke (12) liegt,
**dadurch gekennzeichnet, dass**
die Ansteuerschaltung (3) einen Mikroprozessor (µP) aufweist, wobei der Mikroprozessor (µP) eine Anzahl (n) von Ausgängen aufweist mit je einem ersten Ausgangszustand (low), einem zweiten Ausgangszustand (high) und einem dritten Ausgangszustand (in), und je eine Eingangsschaltung für jeden der Ausgänge, wobei die Eingangsschaltung einen Transistor (T) aufweist, dessen Basis (B) mit dem jeweiligen Ausgang des Mikroprozessors (µP) und über einen ersten Widerstand (R1) mit einer Versorgungsspannung (UB) verbunden ist, dessen Kollektor (C) über einen zweiten Widerstand (R2) mit der Versorgungsspannung (UB) verbunden ist, und dessen Emitter (E) über eine Reihenschaltung aus einem dritten Widerstand (R3) und dem jeweiligen Anzeigeelement (2) mit Masse (GND) zu verbinden ist, wobei in dem ersten Ausgangszustand (low) der jeweilige Ausgang auf Masse (GND) geschaltet ist, in dem zweiten Ausgangszustand (high) der jeweilige Ausgang mit der Versorgungsspannung (UB) beschaltet ist, und in dem dritten Ausgangszustand (in) der jeweilige Ausgang hochohmig geschaltet ist.

2. Anzeigevorrichtung (1) mit einer Ansteuerschaltung (3) nach Anspruch 1,
**dadurch gekennzeichnet, dass**
der erste Anzeigezustand (off) durch den jeweiligen ersten Ausgangszustand (low), der zweite Anzeigezustand (on) durch den jeweiligen zweiten Ausgangszustand (high) und der dritte Anzeigezustand (t) durch den jeweiligen dritten Ausgangszustand (in) des Mikroprozessors (µP) angesteuert wird.

3. Anzeigevorrichtung (1) nach Anspruch 2,
**dadurch gekennzeichnet, dass**
der erste Wert durch den zweiten Zustand (on) des zugeordneten Anzeigeelementes (2) und sämtlicher vorhergehenden Anzeigeelemente (2) dargestellt wird, und der Zwischenwert zu dem nachfolgenden Wert durch den zweiten Zustand (on) des zugeordneten Anzeigeelementes (2) und sämtlicher vorhergehender Anzeigeelemente (2) sowie den dritten Zustand (t) des nachfolgenden Anzeigeelementes (2) dargestellt wird.

4. Anzeigevorrichtung (1) nach Anspruch 2,
**dadurch gekennzeichnet, dass**
der erste Wert durch den zweiten Zustand (on) des zugeordneten Anzeigeelementes (2) dargestellt wird, und der Zwischenwert zu dem nachfolgenden Wert durch den zweiten Zustand (on) des zugeordneten Anzeigeelementes (2) sowie des nachfolgenden Anzeigeelementes (2) dargestellt wird.

5. Anzeigevorrichtung (1) nach Anspruch 2,
**dadurch gekennzeichnet, dass**
der erste Wert durch den zweiten Zustand (on) des zugeordneten Anzeigeelementes (2) dargestellt wird, und der Zwischenwert zu dem nachfolgenden oder dem vorhergehenden Wert durch den dritten Zustand (t) des nachfolgenden oder des vorhergehenden Anzeigeelementes (2) dargestellt wird.

6. Anzeigevorrichtung (1) nach einem der Ansprüche 2 bis 5,
**dadurch gekennzeichnet, dass**
die Anzeigeelemente (2) Leuchtdioden (LED) sind.

7. Anzeigevorrichtung (1) nach einem der Ansprüche 2 bis 6,
**dadurch gekennzeichnet, dass**
die Zustände der Anzeigeelemente (2) Helligkeitswerte der Anzeigeelemente (2) sind.

8. Verwendung einer Anzeigevorrichtung (1) nach einem der vorhergehenden Ansprüche in einem Füllstandsmessgerät.

9. Ansteuerschaltung (3) nach Anspruch 1,
**dadurch gekennzeichnet, dass**
die zweite Stromstärke (12) etwa dem Nennstrom einer als Anzeigeelement (2) verwendeten Leuchtdiode (LED) entspricht, die erste Stromstärke etwa 0 Ampere beträgt und die dritte Stromstärke (13) etwa dem halben Nennstrom der Leuchtdiode (LED) entspricht.

## Claims

1. Control circuit (3) for a display device (1) having a number (n) of display elements (2) which are arranged in a bar-like manner, wherein each display element (2) is capable of showing a first display state (off), a second display state (on) and a third display state (t), wherein the control circuit (3) is formed in such a way that a first value is shown by the second display state (on) of at least one display element (2) allocated to the value, and an intermediate value between the first value and a subsequent or a preceding value is shown by means of simultaneous activation of the preceding or subsequent display element (2), and the first state (off) of the display elements (2) is controlled by a first current intensity (I1), the second state (on) is controlled by a second current intensity (12) and the third state (t) is controlled by a third current intensity (13), wherein the third current intensity (13) lies between the first current intensity (I1) and the second current intensity (12),
**characterised in that**
the control circuit (3) has a microprocessor (µP), wherein the microprocessor (µP) has a number (n) of outputs each having a first initial state (low), a second initial state (high) and a third initial state (in), and each having an input circuit for each of the outputs, wherein the input circuit has a transistor (T), the base (B) of which is connected to the respective output of the microprocessor (µP) and is connected via a first resistor (R1) to a supply voltage (UB), the collector (C) of which is connected via a second resistor (R2) to the supply voltage (UB), and the emitter (E) of which is to be connected to ground (GND) via a series connection of a third resistor (R3) and the respective display element (2),
wherein,
the respective output is connected to ground (GND) in the first initial state (low), the respective output is connected to the supply voltage (UB) in the second initial state (high), and the respective output is connected with high impedance in the third initial state (in).

2. Display device (1) having a control circuit (3) according to claim 1, **characterised in that**
the first display state (off) is controlled by the respective first initial state (low), the second display state (on) by the respective second initial state (high) and the third display state (t) by the respective third initial state (in) of the microprocessor (µP).

3. Display device (1) according to claim 2,
**characterised in that**
the first value is shown by the second state (on) of the allocated display element (2) and of all preceding display elements (2), and the intermediate value with respect to the subsequent value is shown by the second state (on) of the allocated display element (2) and of all preceding display elements (2) as well as the third state (t) of the subsequent display element (2).

4. Display device (1) according to claim 2,
**characterised in that**
the first value is shown by the second state (on) of the allocated display element (2), and the intermediate value with respect to the subsequent value is shown by the second state (on) of the allocated display element (2) and the subsequent display element (2).

5. Display device (1) according to claim 2,
**characterised in that**
the first value is shown by the second state (on) of the allocated display element (2), and the intermediate value with respect to the subsequent or preceding value is shown by the third state (t) of the subsequent or preceding display element (2).

6. Display device (1) according to one of claims 2 to 5,
**characterised in that**
the display elements (2) are light-emitting diodes (LED).

7. Display device (1) according to one of claims 2 to 6,
**characterised in that**
the states of the display elements (2) are brightness values of the display elements (2).

8. Use of a display device (1) according to one of the preceding claims in a filling level measuring device.

9. Control circuit (3) according to claim 1,
**characterised in that**
the second current intensity (12) corresponds approximately to the nominal current of a light-emitting diode (LED) used as a display element (2), the first current intensity is approximately 0 amperes and the third current intensity (13) corresponds to approximately half the nominal current of the light-emitting diode (LED).

## Revendications

1. Circuit de commande (3) d'un dispositif d'affichage (1) comportant un nombre (n) d'éléments d'affichage (2) en forme de bâtonnets,
- chaque élément d'affichage (2) permettant de représenter un premier état d'affichage (arrêt), un second état d'affichage (marche) et un troisième état d'affichage (t),
- le circuit de commande (3) étant réalisé pour qu'une première valeur soit représentée par le second état d'affichage (marche) d'au moins un élément d'affichage (2) associé à la valeur et en ce qu'une valeur intermédiaire entre la première valeur et une valeur suivante ou une valeur précédente soit représentée par l'activation simultanée de l'élément d'affichage (2) précédent ou suivant et en ce que le premier élément d'affichage (arrêt) des éléments d'affichage (2) est commandé par une première intensité de courant (I1), le second état (marche) par une seconde intensité de courant (12) et le troisième état (t) par une troisième intensité de courant (13),
- la troisième intensité (13) étant comprise entre la première intensité (I1) et la seconde intensité (12),
- le microprocesseur (µP) a un nombre (n) de sorties avec chaque fois un premier état de sortie (bas), un second état de sortie (haut) et un troisième état de sortie (in) et chaque fois un circuit d'entrée pour chacune des sorties,
- le circuit d'entrée ayant un transistor (T) dont la base (B) est reliée à la sortie respective du microprocesseur (µP) et par une première résistance (R1) à une tension d'alimentation (UB), le collecteur (C) est relié par une seconde résistance (R2) à la tension d'alimentation (UB) et l'émetteur (E) est relié par le montage en série formé d'une troisième résistance (R3) et d'éléments d'affichage (2) respectifs, à la masse (GND),
- et dans le premier état (bas) la sortie respective est la masse (GND) et dans le second état de sortie (haut) la sortie respective est reliée à la tension d'alimentation (UB) et dans le troisième état de sortie (in) de la sortie respective est mis à un niveau ohmique élevé.

2. Dispositif d'affichage (1) comportant un circuit de commande (3) selon la revendication 1,
**caractérisé en ce que**
le premier état d'affichage (marche) est commandé par la première sortie respective (bas), le second état d'affichage (marche) est représenté par le second état de sortie (haut) respectif et le troisième état d'affichage (t) est commandé par le troisième état de sortie respectif (in) du microprocesseur (µP).

3. Dispositif d'affichage (1) selon la revendication 2,
**caractérisé en ce que**
la première valeur est représentée par le second état (marche) de l'élément d'affichage (2) correspond et tous les éléments d'affichage précédents (2) et la valeur intermédiaire pour la valeur suivante est représentée par le second état (marche) de l'élément d'affichage associé (2) et tous les éléments d'affichage précédents (2) ainsi que le troisième état (t) de l'élément d'affichage (2), suivant.

4. Dispositif d'affichage (1) selon la revendication 2,
**caractérisé en ce que**
la première valeur est représentée par le second état (marche) de l'élément d'affichage associé (2) et la valeur intermédiaire pour la valeur suivante est représentée par le second état (marche) de l'élément d'affichage (2) associé ainsi que par l'élément d'affichage suivant (2).

5. Dispositif d'affichage (1) selon la revendication 2,
**caractérisé en ce que**
la première valeur est représentée par le second état (marche) de l'élément d'affichage associé (2) et la valeur intermédiaire pour la valeur suivante ou précédente est représentée par le troisième état (t) de l'élément d'affichage (2) suivant ou précédent.

6. Dispositif d'affichage (1) selon l'une des revendications 2 à 5,
**caractérisé en ce que**
les éléments d'affichage (2) sont des diodes électroluminescentes (LED).

7. Dispositif d'affichage (1) selon l'une des revendications 2 à 6, **caractérisé en ce que**
les états des éléments d'affichage (2) sont la luminosité des éléments d'affichage (2).

8. Application d'un dispositif d'affichage (1) selon l'une des revendications précédentes à un appareil de mesure de niveau de remplissage.

9. Circuit de commande (3) selon la revendication (1),
**caractérisé en ce que**
la seconde intensité (12) correspond sensiblement à l'intensité nominale d'une photodiode (LED) utilisée comme élément d'affichage (2), la première intensité étant d'environ O ampère et la troisième intensité (13) étant sensiblement égale à la demi-intensité nominale de la photodiode (LED).
